# EUROPEAN PATENT APPLICATION

(11) **EP 1 670 055 A1**
(43) Date of publication of application: **14.06.2006**
(21) Application number: 04447271.0
(22) Date of filing: 09.12.2004
(51) Int. Cl.: H01L 21/78

(54) **Method for chip singulation**

(71) Applicant: INTERUNIVERSITAIR MICROELEKTRONICA CENTRUM vzw (IMEC), 3001 Leuven (BE)
(72) Inventor: Beyne, Eric, 3001 Lleuven (BE); Swinnen, Bart, 3220 Holsbeek (BE); VanHaelemeersch, Serge, 3001 Leuven (BE)
(74) Representative: Van Malderen, Joëlle

(57) **Abstract**

The present invention is related to a method for singulating a chip from a stack of layers, said stack comprising a front end of line (FEOL) (5) upon a substrate layer (1), said substrate layer having a first and second surface, said FEOL (5) being positioned on top of said first surface, and a back end line (BEOL) (6) on top of said FEOL, said method comprising the steps of:
- etching singulating trenches through said BEOL (6), through said FEOL (5) and at least partially through said substrate layer (1) of said stack,
- depositing a passivation layer on said stack provided with singulating trenches, whereby also said trenches' sidewalls are at least partially passivated,
- reducing the thickness of said substrate layer from said second surface onwards until said chip is released from said stack.

## Description

### Field of the invention

The present invention relates to the field of semiconductor processing. More specifically it relates to methods for wafer dicing.

### State of the art

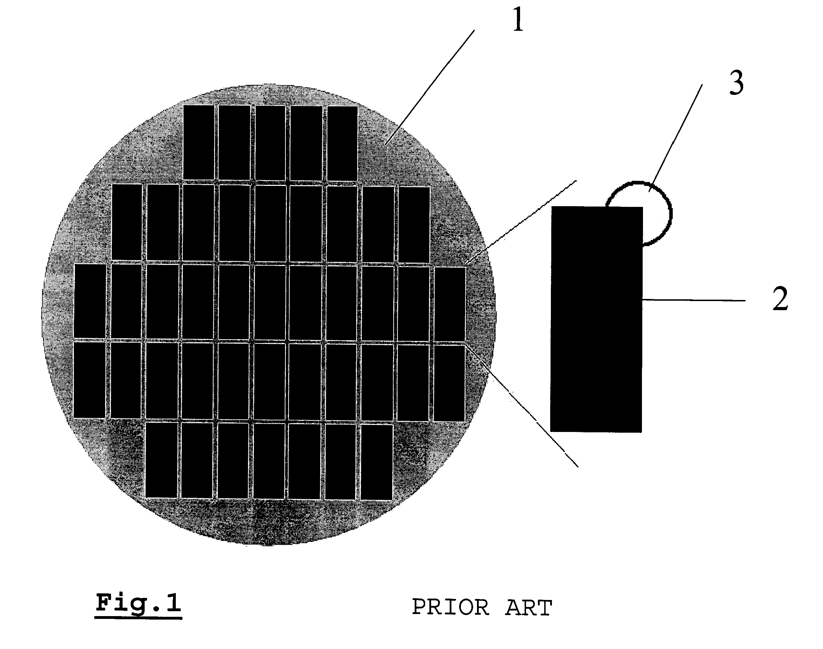

Die or chip singulation is the separation of different dies (2) on a wafer (1) (see Fig.1). It is the first of all assembly steps.

Die singulation by means of classical blade dicing is standard practice: dies are cut with a rotating wheel while a rinsing solution is spilled over the wafer in order to remove particles induced by the saw. This method requires dicing streets with a width of several tens of micron and gives rise to considerable sidewall damage (chipping, cracking). Especially when dicing through areas that contain metal dummies, which are present in copper damascene processing, the damage caused by ripping the metal pads out of the stack during dicing may be extensive.

Laser cutting is an alternative to classical blade dicing: here applying a laser beam onto it, evaporates material in the scribe lanes. This method is not subject to chipping; however, the heat generated by the laser beam may affect the properties of the material next to the dicing street. Hence an exclusion area where no circuitry is allowed is required near the dicing streets. Even without taking the heat-affected zone into account, the dicing streets achieved in this way are between 15 and 30 micron wide. No laser dicing solution exists that can cut through a stack with dummy metal pads in the scribe lanes.

Wafers or substrates are processed until completion of deposition, patterning and polishing of the last metal level below a passivation layer. A passivation layer is commonly known as a protective layer to assure the chemical stability of the layer(s) below. Both classical blade and laser dicing are performed after completion of the full wafer including passivation stack. Depending on the assembly route, a number of wafer level processes may be performed between passivation deposition and singulation (e.g. under bump metallisation (UBM) /solder plating/redistribution layer deposition).

Trench etch dicing is a known technique, for instance from Advanced Packaging Materials, Processes, Properties and Interfaces, Proceedings of IEEE 01TH8562, ISBN 0-930815-64-5, pp.92-97. Here, after completion of the wafer back end and the passivation stack, dicing streets are imaged and subsequently etched. This process gives rise to die edges that are very well defined (no chipping or cracking).

Trench etch dicing is capable of reducing considerably the scribe lane width required for dicing. In practice, the Si-gain is often limited by the fact that scribe lanes also contain electrical test structures and alignment features, which imposes a lower limit on the scribe lane width. Whereas blade dicing and laser dicing are performed scribe-by-scribe, trench etch dicing is a true wafer level process.

In all above processes, die singulation is performed after passivation. Hence: in all these processes, after singulation, only the top area of the die is passivated. Die edges are not protected.

### Aims of the invention

It is an aim of the present invention to provide for a method for wafer dicing, which alleviates or avoids the problems of the prior art.

### Summary of the invention

The present invention relates to a method for singulating a chip from a stack of layers, said stack comprising a front end of line (FEOL) upon a substrate layer, said substrate layer having a first and a second surface, said FEOL being positioned on top of said first surface, and a back end of line (BEOL) on top of said FEOL, said method comprising the steps of :
- etching singulating trenches through said BEOL, through said FEOL and at least partially through said substrate layer of said stack,
- depositing a passivation layer on said stack provided with singulating trenches, whereby also said trenches' sidewalls are at least partially passivated,
- reducing the thickness of the substrate layer from the second surface onwards and at least in the region between the second surface and the bottom of the singulating trenches until the chip is released from the stack.

In a preferred embodiment said BEOL is provided with metal dummies positioned outside a zone comprising the area of said chip and outside an exclusion zone around said chip area.

Advantageously the exclusion zone is used for etching the singulating trenches.

Preferably the step of etching singulating trenches is performed in back end of line processing technology.

In another preferred embodiment the method further comprises a step of etching holes for interconnects in said chip area.

In an alternative embodiment damascene processing is performed for said BEOL.

Advantageously the step of etching singulating trenches comprises a step of using a mask with patterns corresponding to dies with rounded corners.

The present invention can be particularly advantageous if the BEOL is produced by low-K processing.

### Short description of the drawings

Fig. 1 represents a prior art solution, whereby die singulation can be achieved by blade dicing, laser cutting or trench etch dicing.

Fig. 2 to Fig.5 illustrate the various steps of the method according to a preferred embodiment of the present invention.

Fig. 6 represents a cross sectional view is shown of a prior art embodiment (left) compared to the embodiment according to the present invention (right). From the beginning, an exclusion zone is foreseen, comprising no metal dummies, around the chip areas. Here, by means of example, the exclusion zone is a collection of squares around the respective chips.

Fig. 7 represents a top view of the matter depicted in Fig. 7.

Fig. 8 shows another type of exclusion zone.

Fig. 9 represents some more examples of exclusion zones.

Fig. 10 shows an embodiment of the present invention, providing rounded vertical chip corner edges.

Fig. 11 represents an embodiment of the present invention whereby next to the etching of trenches aimed at chip singulation, additional features like holes are etched within the chip area.

### Detailed description of the invention

The present invention will be described with respect to particular embodiments and with reference to certain drawings but the invention is not limited thereto but only by the claims. The drawings described are only schematic and are non-limiting. In the drawings, the size of some of the elements may be exaggerated and not drawn on scale for illustrative purposes.

Furthermore, the terms first, second, third, and the like in the description and in the claims, are used for distinguishing between similar elements and not necessarily for describing a sequential or chronological order. It is to be understood that the terms so used are interchangeable under appropriate circumstances and that the embodiments of the invention described herein are capable of operation in other sequences than described or illustrated herein.

Moreover, the terms top, bottom, over, under, and the like in the description and the claims are used for descriptive purposes and not necessarily for describing relative positions. It is to be understood that the terms so used are interchangeable under appropriate circumstances and that the embodiments of the invention described herein are capable of operation in other orientations than described or illustrated herein.

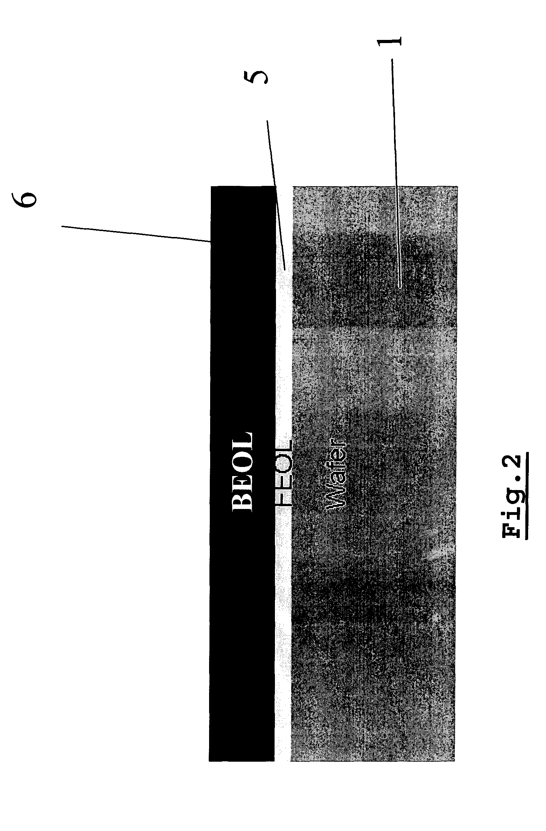

The present invention discloses a method for singulating chips from a stack of layers. The stack (see Fig.2) is obtained by first providing a substrate layer (1) having a first and a second surface. Then, on top of said first surface the front end of line (FEOL) (5) is processed and then the back end of line (BEOL) (6) is processed on said FEOL. The front end of line is commonly known as the layers in a semiconductor stack up to first interconnect metallisation level that contain active devices. The back end of line is commonly known as the layers in a semiconductor stack following the first metallisation level and before the passivation layer(s).

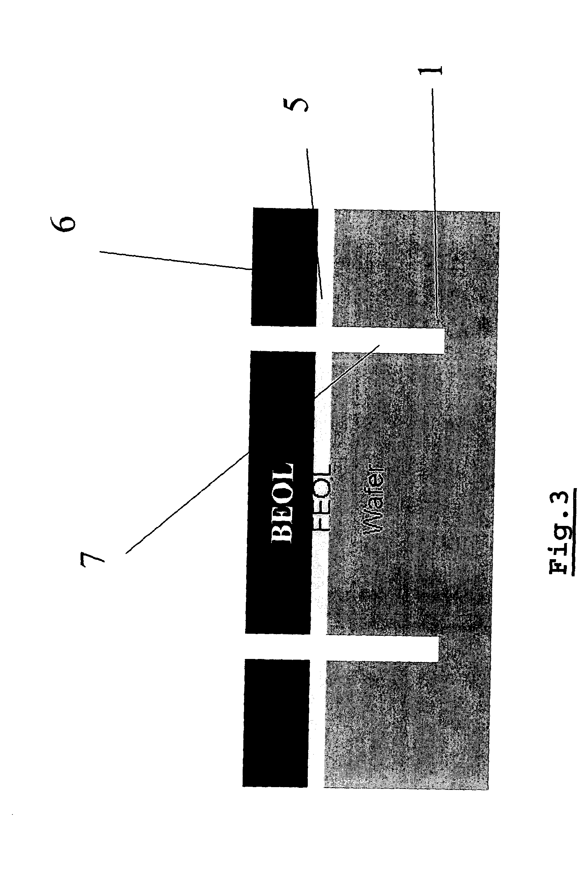

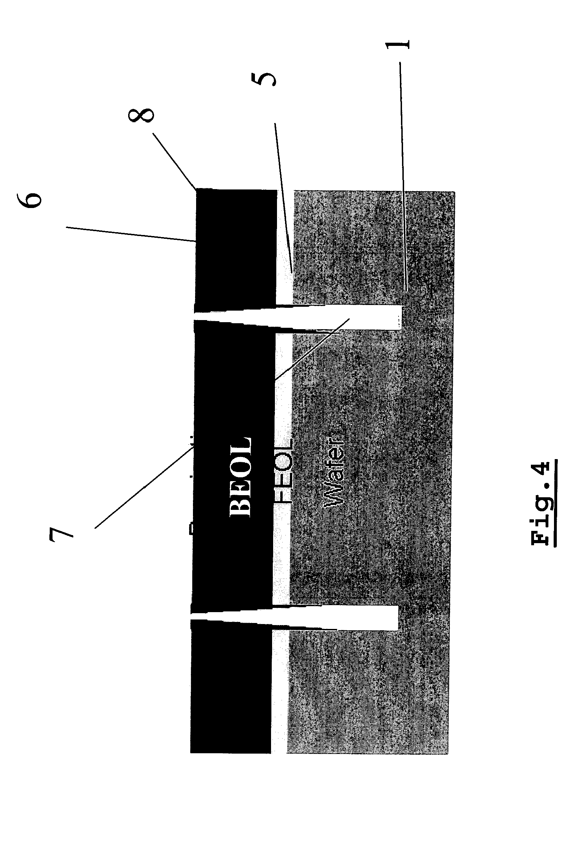

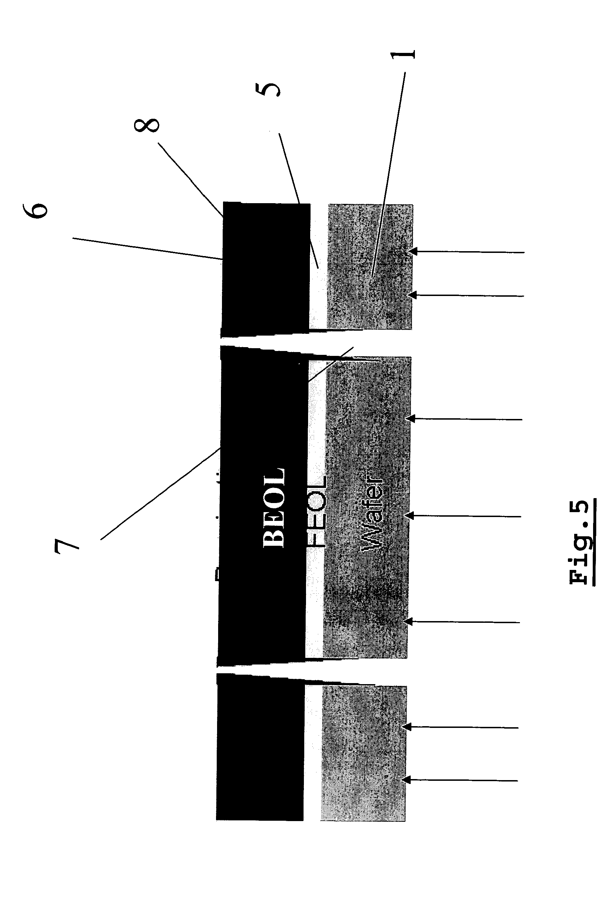

The method comprises the following steps :
- etching singulating trenches (7), hereby going through the BEOL, through the FEOL and at least partially through into said substrate (Fig.3),
- depositing a passivation layer (8) on the stack, now provided with singulating trenches (7), hereby passivating the upper surfaces of the chips to be singulated as well as the sidewalls of the singulating trenches that in a later stage will constitute the side surfaces of the chips (Fig.4),
- reducing the thickness of the substrate layer from the second surface onwards (thus from the bottom side of the stack) and at least in the region between the second surface and the bottom of the singulating trenches, until the individual chips are released (Fig.5).

A major advantage of the present invention is the presence of a step of depositing one or more passivation layers (8) on top of the stack after having provided singulating trenches. Hereby one passivates the upper surface or top of the stack comprising the chip to be singulated as well as the sidewalls or side surfaces of the chip. Hereby the sidewalls of the BEOL and the FEOL can be passivated. As already discussed, in the prior art the singulation process is performed completely after passivation, resulting in unpassivated sidewalls.

The passivation material is application dependent and can comprise for instance SiC, Silicon dioxide, Silicon Nitride, SiON, BenzoCycloButene (BCB) or a combination of these or other materials. The passivation layer can comprise different sub layers, made out of different materials. For instance the passivation layer can be a tri-layer. It can be for instance a SiC/ SiO /SiN₄ layer as for instance 50 nm SiC / 330 nm SiO₂ / 500 nm SiN₄ for a copper process. For an Aluminum process it can be for instance a SiN₄ layer. The required minimum thickness depends on the sensitivity to contamination of the underlying chip. The passivation layer can be deposited by state of the art techniques as Physical Vapour Deposition (PVD) or Chemical Vapour deposition (CVD). Some materials (e.g. BCB) can be spun on.

This aspect of the present invention enhances the reliability of dies that incorporate moisture sensitive materials such as, but not only, low-K dielectrics and may eliminate the need for space consuming sealing rings around the die active area, as shown in prior art.

An additional step of typically temporarily attaching the stack of layers comprising singulation trenches to an adhesive film or foil before releasing the individual chips can be performed in another preferred embodiment.

The substrate can essentially be any substrate, which allows etching narrow trenches (1, 2, 3, 4, 5,10, 15, 20 µm wide for instance). It can be any semiconductor substrate, for instance, but not only, a silicon substrate, a GaAs substrate or a Germanium substrate. The layer at the top of the substrate (or on top of the substrate depending on the view), for instance Si substrate, or on top of the buried oxide in Silicon on Insulator (SOI) substrates in which transistors are built, is an active layer. Below the active layer the substrate (e.g. Si substrate) is present to provide mechanical support. The trenches should be deeper than the combined thickness of chip and active layer thickness in the substrate. They can be for instance between 20 and 100 or 200 µm deep.

The step of etching singulating trenches should be such that it can etch the back end of line, the front end of line and at least a part of the substrate. Dielectrics such as SiO₂, low-K materials, and barrier layers must possibly be etched. The etched trenches are preferably as narrow as possible, for instance 20 *µ*m or below (cfr.supra). The minimum width is determined by the applied technology. For certain passivation layers a minimum width is necessary though to allow the passivation layer to penetrate sufficiently deeply into the trenches to cover the sidewalls.

The step of reducing the thickness of the substrate from the bottom side of the stack can be for instance a polishing step as for instance a Chemical Mechanical Polishing (CMP) step, a grinding step or a substrate etch back. The final chip thickness is limited by the limitations of state of the art techniques. It can be for instance thinned up to 200, 150, 130, 100, 90, 80, 70, 60, 50, 40, 30, 20, 10 *µ*m or less.

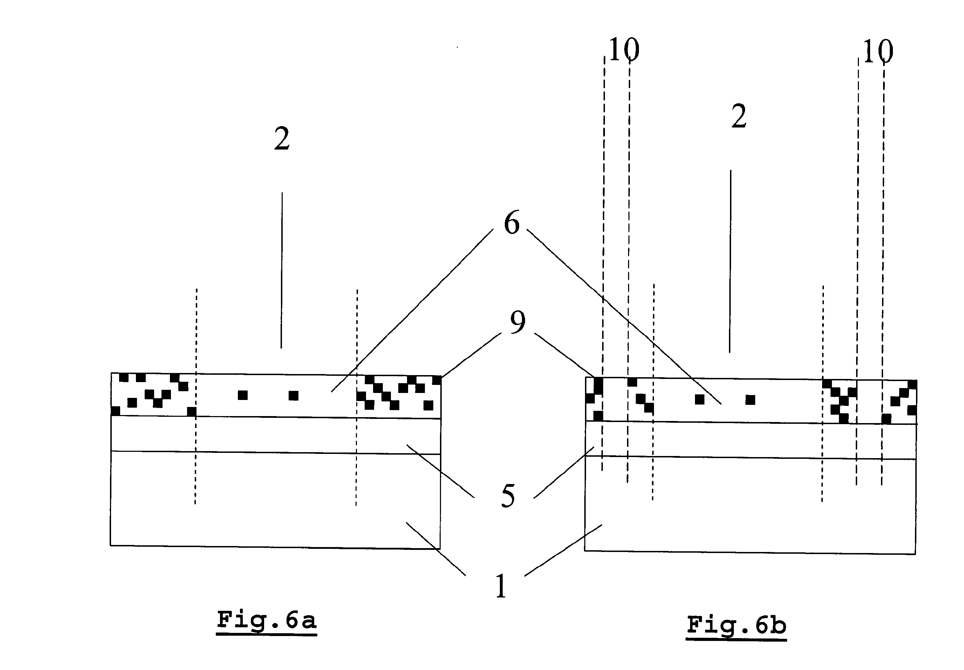

Certain aspects of the present invention more particularly refer to the field of damascene processing; hereby subtractive etch steps are performed in a deposited layer, followed by deposition of a metal and a flattening (e.g. polishing) step, after which a new layer can be deposited. In such processing typically metal (for instance copper) dummies (9) (Fig. 6) are processed at the same time with the processing of the BEOL, because of the well achievable uniformity after polishing during damascene processing. Damascene processing can be for instance Copper (Cu)-damascene, Aluminium (Al) damascene or Wolfram (W) Damascene. A special case of such damascene processing can be Cu/low-K applications.

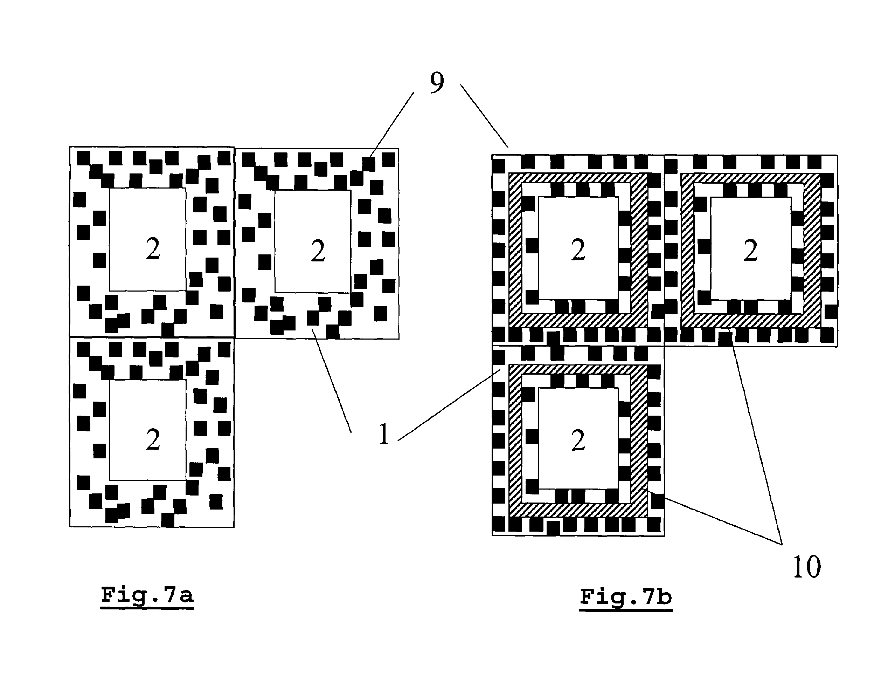

In typical damascene processing metal dummies are provided in the scribe lanes, such that they often cover the whole scribe lane area, when looked upon from above (see Fig. 6, left and Fig. 7, left).

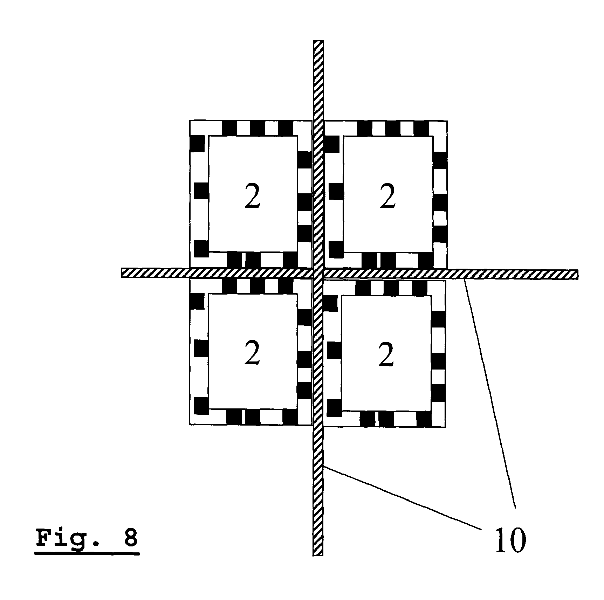

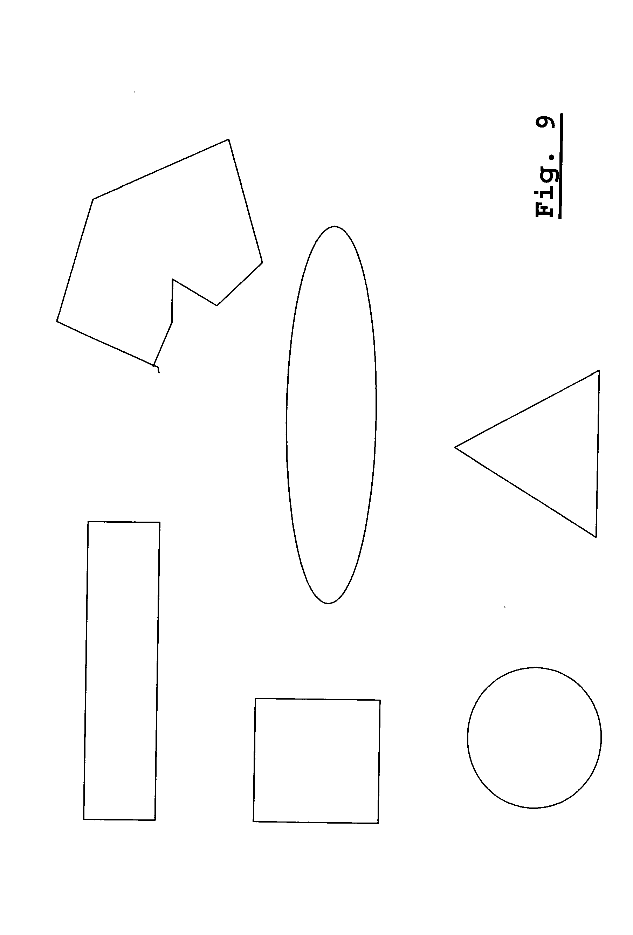

In an advantageous embodiment metal dummies are produced in the areas outside the area of the chip(s) during the BEOL processing. However, etching through metal is cumbersome. Therefore said metal dummies are positioned such that a metal exclusion zone (10) is foreseen, where no metal is present in any of the layers processed prior to etching the scribe lanes. The exclusion zone is placed around the chip area and is such that a line can be drawn in it that surrounds said chip area. In other words, it should enclose the chip area. The width of the exclusion zone may for instance be 15 *µ*m. So, when looking or projecting from above, a trench area is left open, where no metal is present. The exclusion zone is used for etching the singulating trenches (see Fig. 6, right side and Fig. 7, right side). The exclusion zone may be comprised in the scribe lanes between the die. The width of the singulating trenches and thus exclusion zone can be smaller than the size of the copper dummies or smaller than a typical inter dummy distance. The metal exclusion zone enables trench etch dicing for damascene processing. Fig.8 shows an alternative type of exclusion zone, whereby a lattice is formed between the chips. Fig.9 shows some more examples of exclusion zones, which preferably correspond to similarly shaped chips. In principle any form of exclusion zone and trench can be used.

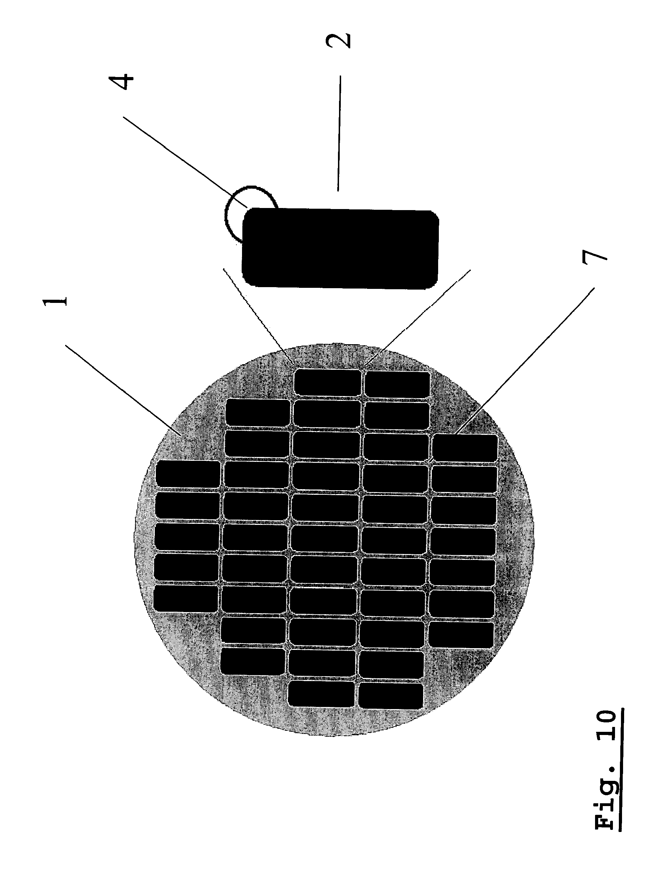

As a further advantage of the present invention, the step of providing singulating trenches can be chosen such that it produces rounded vertical chip corner edges (4) (Fig. 10). This can be achieved by performing the die singulation by exposing the wafer in a stepper or mask aligner with an image that defines the dicing streets and where, at crossover of different dicing streets die corners are rounded. A mask with rounded die edges can be used for instance. This reduces the stress concentrations that occur near die corners (3) (see prior art, Fig.1). This is especially relevant for thin die, which are particularly sensitive to such stresses. Square die corners, as present in state of the art methods, lead to stress pile up especially in thin dies (for instance between 5 and 100 µm thick). Therefore the present invention provides for a reduction of stress sensitivity of the chips, resulting in a higher yield and reliability. This can be particularly advantageous for low-k applications.

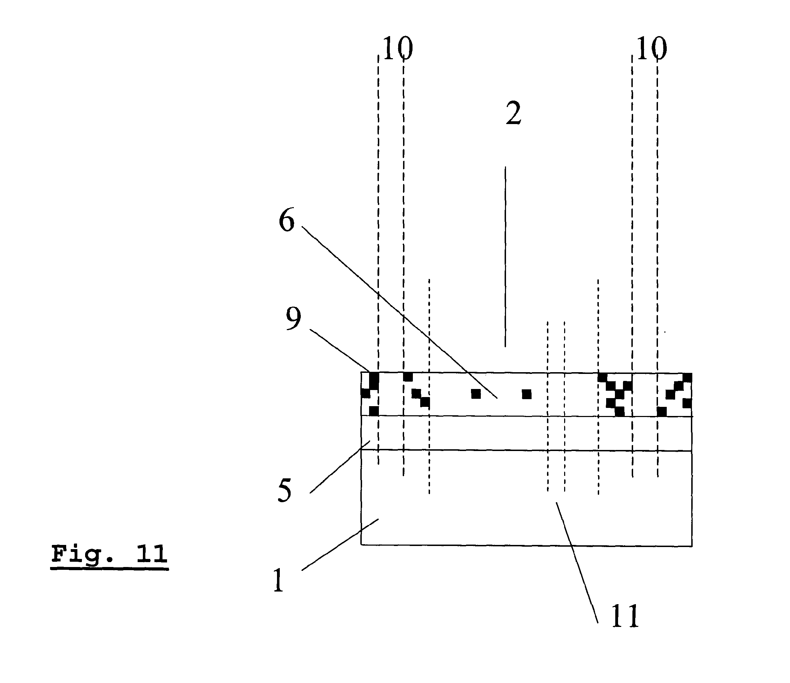

In a further embodiment (Fig.11) the method according to the present invention can comprise a step wherein additional features as holes (11) are etched within the chip area. Such holes may also be trenches (not be confused with singulating trenches!), which for instance, but not only, can be part of a MEMS device or serve as an isolation trench. During the flattening step these holes can also be reached, hereby creating through holes. Such through holes can be used for instance for electrical or optical interconnections. This step can be performed together with the step of etching singulation trenches, i.e. in the same technology.

## Claims

1. Method for singulating a chip from a stack of layers, said stack comprising a front end of line (FEOL) (5) upon a substrate layer (1), said substrate layer having a first and a second surface, said FEOL (5) being positioned on top of said first surface, and a back end of line (BEOL) (6) on top of said FEOL, said method comprising the steps of :
- etching singulating trenches through said BEOL (6), through said FEOL (5) and at least partially through said substrate layer (1) of said stack,
- depositing a passivation layer on said stack provided with singulating trenches, whereby also said trenches' sidewalls are at least partially passivated,
- reducing the thickness of said substrate layer from said second surface onwards and at least in the region between said second surface and the bottom of said singulating trenches until said chip is released from said stack.

2. Method for singulating a chip as in claim 1, wherein said BEOL (6) is provided with metal dummies positioned outside a zone comprising the area of said chip and outside an exclusion zone around said chip area.

3. Method as in claim 2, wherein said exclusion zone is used for etching said singulating trenches.

4. Method as in any of claims 1 to 3, wherein said step of etching singulating trenches is performed in back end of line processing technology.

5. Method as in any of the previous claims, further comprising a step of etching holes for interconnects in said chip area.

6. Method as in any of the previous claims, wherein damascene processing is performed for said BEOL.

7. Method as in any of the previous claims, wherein said step of etching singulating trenches comprises a step of using a mask with patterns corresponding to dies with rounded corners.

8. Method as in any of the previous claims, wherein said BEOL is produced by low-K processing.
